Europäisches Patentamt

**European Patent Office**

Office européen des brevets

(11) Publication number: **0 079 762**
**A2**

(12) # EUROPEAN PATENT APPLICATION

(21) Application number: **82306004.1**

(22) Date of filing: **11.11.82**

(51) Int. Cl.³: **H 01 L 25/04**

(30) Priority: **12.11.81 GB 8134188**

(43) Date of publication of application:
**25.05.83 Bulletin 83/21**

(84) Designated Contracting States:
**AT BE CH DE FR GB IT LI LU NL SE**

(71) Applicant: **TACTICAL AND NAVIGATIONAL SYSTEMS LIMITED**
**83-91 Victoria Street**
**London SW1H OHW(GB)**

(72) Inventor: **Salusbury-Trelawny, Simon Jonathon**
**67 Westover Road**
**London SW18 2RF(GB)**

(72) Inventor: **Wright, Robert Douglas**
**205 ELm Avenue Glenriddle**
**Philadelphia Pennsylvania 19037(US)**

(74) Representative: **Harrison, David Christopher et al,**
**MEWBURN ELLIS & CO 2/3 Cursitor Street**
**London EC4A 1BQ(GB)**

(54) Photovoltaic panels and methods of making them.

(57) A photovoltaic panel has photovoltaic crystals (32) held between otherwise contiguous surfaces of two layers of elastomeric material (30,44,52). One layer (30,44) is transparent and has two sub-layers (30,44) with electric interconnections between the crystals (32) being held between otherwise contiguous surfaces of the sub-layers (30,44). A transparent self-supporting plate (46) of plastics material lies over the transparent elastomeric layer (30,44) and its outer surface (54), which forms the light-receiving surface of the panel, is pyramidally honeycombed, as this configuration reduces reflection and increases the amount of light absorbed as compared with a flat panel, particularly at large angles of incidence. To form the panel the crystals (32) are laid on a template (34) and inter connected. Then they are covered by the transparent elastomer (30,44) and then with the self-supporting plate (46). The assembly is then inverted and the other elastomer layer (52) formed over it.

Fig.4.

## PHOTOVOLTAIC PANELS AND METHODS OF MAKING THEM

The present invention relates to photovoltaic panels, namely panels which convert electromagnetic radiation directly into electrical power.

The crystals used in these panels, as is well known, are silicon crystals of which one surface is doped. These are connected together in series in an array of such crystals to give desired amperage and voltage characteristics from the array.

For greatest efficiency the crystals must be as thin as possible and this renders them extremely fragile and difficult to handle during manufacture and assembly of the panel and during its use.

The present invention is concerned to provide several improvements in the nature and manufacture of solar panels from these very fragile and delicate crystals so as to provide robust panels and an efficient and economic method of manufacture. The panel preferably has a symmetric array of crystals.

In a firstaspect of the invention we are concerned to provide a panel in which the crystals and their interconnections are supported firmly. The standard method of supporting the crystals is to sandwich them between a base layer and a sheet of glass which is secured at its edges to the base layer. The crystals are then held in place by mechanical pressure transmitted from the edges of the glass. However, this structure has a number of disadvantages which make the standard panel of little value in extreme conditions and for military applications. The most important disadvantage is the fact that the glass is brittle and therefore the panel cannot withstand sudden shocks and vibrations. Since any crack in the glass reduces the mechanical pressure over the whole panel (because the pressure is dependent on the transmission of pressure from the edge of the glass to each crystal), the cracking of the glass causes complete failure of the panel.

The present ivnention seeks to overcome this problem by defining one face of the panel with a self-supporting plate and using this as a base upon which the crystals are "floated" on transparent elastomeric layer, preferably formed by a clear gel. The clear gel layer may comprise two individual sub layers applied successively, and used respectively for supporting the crystals and for guiding interconnecting electrical elements between the crystals. The supporting plate forms the light receiving surface and is therefore transparent. Behind the crystals and overlying the surface of the clear gel is another elastomeric layer as a sealant which should be comparatively robust and may be opaque. Furthermore, this may be coloured so as to impart to the panel when viewed through the light receiving surface any desired appearance or characteristic. The sealant elastomer may be surgical silicon rubber formed as a pre-formed solid sheet which is fitted behind the crystals. Preferably, however, the sealant elastomer is formed from surgical silicon gel in a similar way to the silicon gel layers in front of the crystals.

This enables a flexible panel to be manufactured. Because of the rigidity and the fragility of the crystals which are used in it, this has been regarded as entirely impossible, so far as we are aware. However, in many extreme conditions, a flexible panel is not sufficiently robust. Therefore it is preferable that the self-supporting plate imparts substantial rigidity to the panel. The rigidity of the panel may be increased by providing a substantially rigid backing plate behind the sealant elastomer. This backing plate is secured to the edges of the self-supporting plate.

The method of manufacture of such panels includes placing an array of crystals in a template and either previously or thereafter interconnecting them electrically, pouring over the face of the template and the exposed light receiving surface of thecrystal one layer or more of clear gel, providing a self-supporting plate and inerting the assembly of crystals and of clear gel to secure the uninterrupted face of the gel onto the rear face of the supporting material, and sealing over the rear faces of the crystals and of the clear gel with a sealant elastomeric layer.

Another disadvantage of standard photovoltaic panels is that glass reacts with ultra-violet light and as it ages, transmits a decreasing amount of light. In order to overcome this disadvantage in the panel of the present invention it is preferable to make the self-supporting plate of an ultra-violet stabilized plastics material such as "PLEXIGLASS G" (an acrylic resin) or polycarbonate. The layer(s) of elastomeric gel on which the crystals are "floated" may also be ultra-violet stabilized.

The standard panels have a flat light-receiving surface. This has the disadvantage that the panel reflects a large proportion of light incident on it, particularly at low angles of incidence, thereby reducing its efficiency. The high reflectivity of the standard panels makes them unsuitable for military applications. Therefore, in a second aspect of the present invention the light-receiving surface of the self-supporting plate is pyramidally honeycombed, the peaks of the pyramids of which project inwardly and outwardly of a median plane of the honeycombed surface. This provides a surface which has a very high light collecting area from as wide as possible a range of angles, a comparative lack of internal reflection and presents a non-reflective view from the point of view of appearance. The inner layer of the plate is essentially flat.

Another feature of the first two aspects of the invention is the use, as the interconnecting element between crystals in the array, of braided discrete flexible conductors electrically interconnecting one face of one crystal with another face of another. It is conventional in the building of panels to use a trace of a conductor metal formed on the rigid supporting back of the panel, to interconnect collecting bars formed on the crystals.

In the standard panel the interconnection is by (unbraided) strips of conductor and it is a disadvantage of this construction that it is prone to fracture of the interconnections due to thermal expansion and contraction. This is of particular importance in desert conditions where the difference between the maximum daytime temperature and the minimum night-time temperature is high. The use of braided flexible conductors permits thermal expansion and contraction.

Furthermore, our use of braided flexible conductors which are preferably braided silver wire allows us multiply to interconnect 2n crystals of the array of crystals where n is an integer greater than two. This forms groups of n crystals with each crystal belonging to n groups. In this way the array of crystals remains fully functional even if (n-1) of the crystals of any group of n should be rendered inoperative. A preferred number for n is 3, but n should be not less than 2 as n=1 merely represents a simple series connection of the crystals and the panel is rendered inoperative if any one crystal fails.

This feature of multiple interconnection of crystals in an array of crystals in a photovoltaic panel, in order to avoid failure of the panel as a whole when a comparatively small number of crystals are rendered inoperative, is independently an aspect of this invention, (the third aspect) this valuable feature being applicable equally to panels which are in other respects conventional.

In order to prevent the application of back potentials when one or more crystals of the group are rendered inoperative, each connector must be unidirectionally conducting, and this is conveniently achieved by the incorporation into each connector of a diode. Further, to increase the resistance of the panel as a whole to failure of any one or more of the crystals, leads from each of the last n crystals at each end of the array are taken to a final output bar, at spatially separated positions along the bar. The bar is connected to an output lead containing a diode to prevent back-current from voltage sources in the load.

Another feature of the present invention concerns the formation upon the light receiving surface of each crystal of the collecting network or grid of conductors. There is a difficult and fine balance to be struck between obscuring the interface of the dope and undoped parts of the crystal from the radiation which is to energise it and achieving efficient collection of the electrical energy generated at that interface. For the former, one needs as little as possible opaque conductor, for the latter as much as possible. Conventionally such networks have been manually applied to the surface of the crystal by drawing on that surface with a silver trace pen which deposits from liquid a coherent silver line. Usually these are drawn more or less parallel across the relevant face of the crystal and brought to a single collecting bay at one end of the crystal. However, a generally radiating pattern to the face of the crystal may be applied, originating from an essentially point-like contact at the origin of the lines, from which point the connecting conductor is taken.

Embodiments of the present invention will now be described in detail, by way of example, with reference to the accompanying drawings in which:

Figure 1 is a diagrammatic plan view of a photovoltaic crystal showing the conductive backing;

Figure 2 shows the interconnection of photovoltaic crystals according to the third aspect of the present invention;

Figure 3 shows the formation according to the present invention of gel layers on a photovoltaic cell;

Figure 4 is a sectional view through a photovoltaic panel according to the present invention;

Figure 5 is a graph of the charging rate produced by a photovoltaic cell covered with a glass panel; and

Figure 6 is a graph of charging rate produced by a photovoltaic cell covered with a facing layer with a pyramidally honeycombed surface.

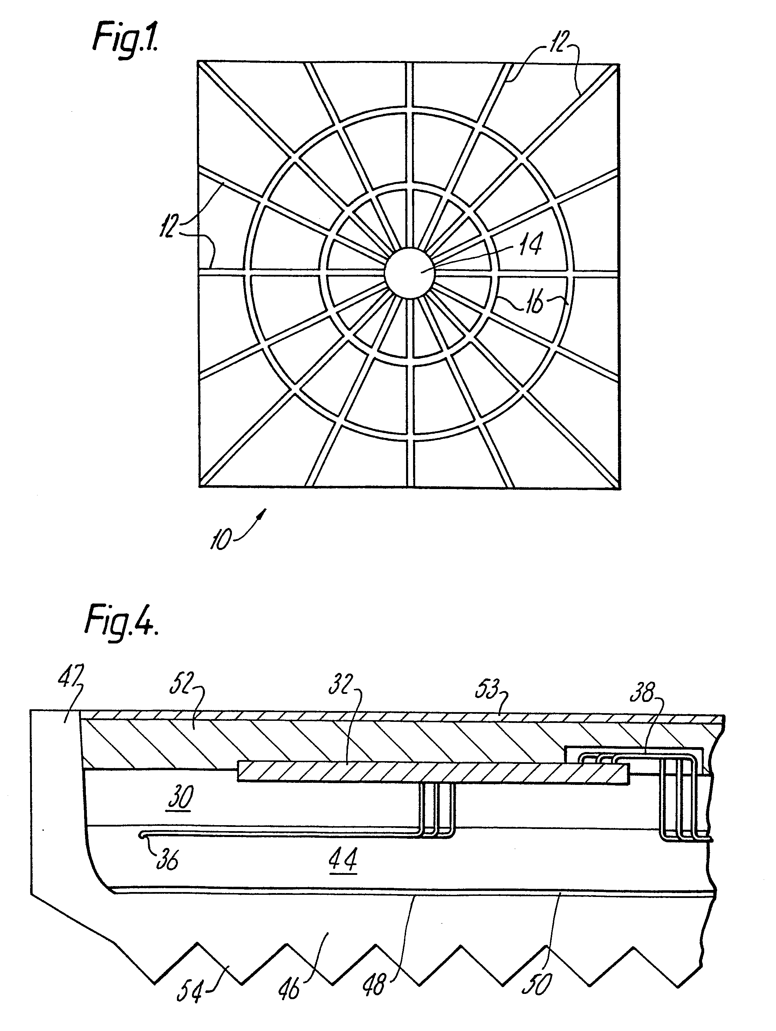

Referring first to Figure 1, a crystal of semiconductor material, e.g., silicon is cut using a laser to produce an extremely thin wafer. The silicon should be extremely pure, and an average efficiency of 15.15% can be achieved with a suitably pure crystal. Normally, photovoltaic crystals are circular but in the present invention, they are cut to a rectangular or square shape as this allows the cells in an array of cells in a photovoltaic panel to be positioned so that, for a given size of array, the area occupied by the cells may be maximised.

One surface of the crystal is then doped electrolytically with boron silver to create a p-n junction within the crystal. When light is incident on the cell 10, an electromotive force is generated across the p-n junction. The voltage produced is independent of the area of the cell 10. Depending on the doping the voltage across the cell can be between 1 volt and 4.2 volts. However, the current produced depends on the area of crystal which receives light. It is desired to maximise the power from the cell which depends on both current and voltage.

In this embodiment, the undoped surface is the surface on which light is incident (hereinafter the light receiving surface) and this generates an electromotive force across the thickness of the cell 10. When the cell 10 is connected into a circuit, current flows into the doped surface and out of the un-doped surface. An electrical connection to the doped surface can be a single conductor which is fused into the crystal surface. To extract current from the un-doped surface however, a fine network of conductive tracks 12 are provided.

The conductive tracks may be formed as follows:

1) A mask of petroleum gel is formed on the surface of the crystal, the mask having apertures where the tracks 12 are to be formed.

2) The crystal is dipped into an electrolytic solution of boron silver and a current is passed through the solution to deposit conductive material on the crystal through the apertures in the mask.

3) The mask is removed by heating, when it melts off, any traces remaining merging with the clear gel about to be described.

This electrolytic method of forming the conductive tracks on the crystal permits mechanisation of the process which is less labour intensive than the standard method of painting the tracks by hand onto the crystal. The resultant track can also be much narrower than the track produced by the standard manual methods; widths of 0.2mm, for example, can be obtained.

Alternatively, the conductive tracks may be formed by atomic bombardment. Silver or other conductive material is vapourised and the crystal is bombarded with the atomic silicon via a mask. Some of the atoms of silicon penetrate a short distance into the crystal thereby securing the tracks firmly to the crystal. The pattern of the tracks is determined by the mask.

Other methods of masking, e.g. by a silk screen, may achieve good results.

In the embodiment illustrated, the conductive tracks 12 are formed in a radiating pattern from a central electrode 14. This pattern of tarcks 12 has been found to provide more efficient current collection than the standard parallel tracks, especially if intermediate endless tracks 16 interlink them. However, such radial tracks are more difficult to form than parallel tracks and in some cases this factor outweighs the improved results obtained. Therefore in a second embodiment (not illustrated) the tracks are formed in parallel.

As mentioned above, the deposition of the pattern can be achieved in a number of ways. The simplest method is by silk screen printing. However, a greater degree of reliability and reproducability can be achieved by depositing the pattern, for example as shown above, by electro-deposition from silver solution after masking of the surface of the crystal. The optimum method found so far, is however by atom bombardment. This has the advantage that the atoms of the conductive network penetrate into the crystal thereby preventing any risk of fracture of the network (excluding fracture of the crystal itself).

Once the conductive tracks have been formed on the crystal and the mask removed, the cell is then ready for connection to other cells to form an array. First, three conductive braids are fused into the doped surface of the crystal. These conductive braids are each made of 18 strands of silver wire plaited together to form a single conductive lead. A plurality of such cells are then carefully placed with their doped surface downwards on a perspex template and the braids are lifted upwards and held above the cells. It is important that the braids do not contact any surface of the crystal as a scratch will irreparably damage the crystal structure. Therefore, at this stage, all the braided leads are held clear of the crystals in the array. This can be achieved by a series of wooden supports extending across the array over which the leads pass.

The template itself is provided with recesses into which the cells are received. These recesses are positioned so that the cells form the desired array. If square cells are used, it is preferable that the array is a chequered pattern with a small spacing between adjacent cells.

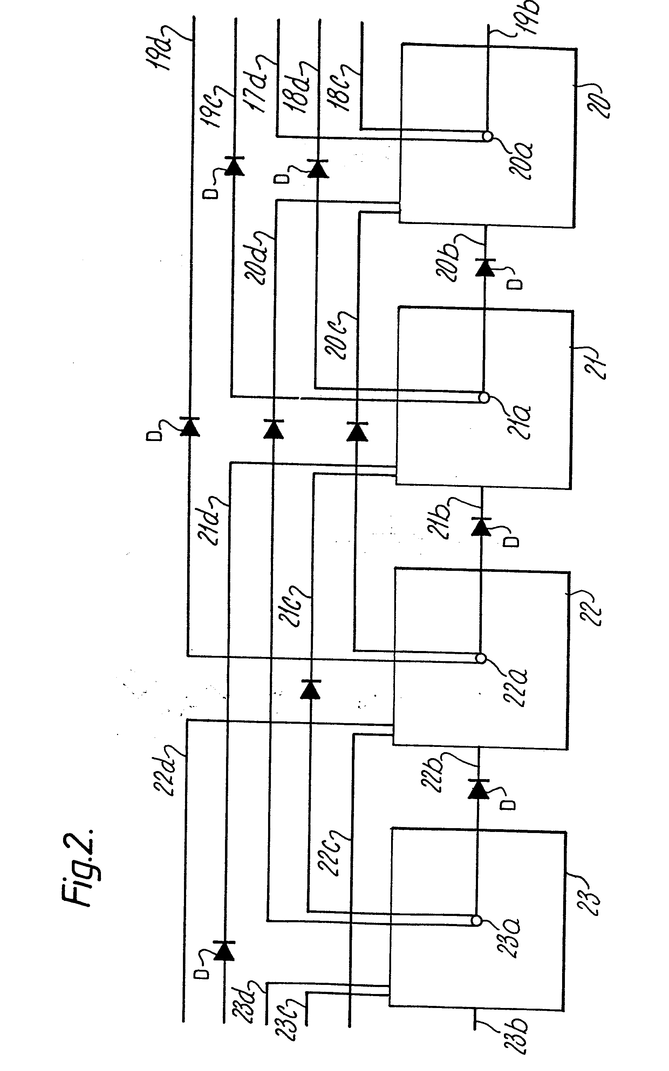

Once the cells are in position on the template, they are interconnected. As shown in Figure 2, a series of cells 20 to 23 are interconnected by a series of braided leads, each of which contains a diode to prevent back-current. Starting at cell 20, that cell has three leads 20b, 20c and 20d extending from its doped surface. The first of these 20b, is connected directly to the central electrode 21s of the immediately preceding cell 21. The second 20b extends past the immediately preceding cell 21 to the central electrode 22a of the preceding cell but one. The third lead 20c from cell 20 extends to the central electrode 23a of the preceding cells but two. In this way the cell 20 is connected to each of the three preceding cells 21 to 23 in the array. This process is repeated for each of the cells in the array. Thus leads 21b, 21c, 21d from cell 21 extend to cells 22, 23, and the cell preceding cell 23 respectively, and similarly for leads 17d, 18c, and 18d, 19b to 19d from cells subsequent to cell 20 and for leads 22b to 22d and 23b to 23d from cells 22 and 23.

An elongate conductive bar is provided at each end of the array for connection to input and output leads respectively extending to the load. One of these leads contains a diode to prevent back-currents from the load (e.g. a fully charged battery) damaging the panel. The bar at the input end of the panel is connected to the first three cells in the array, and the bar at the output end is connected to the last three cells. In this way, failure of the first or last cell in the array does not prevent operation.

This interconnection system has the advantage that if one or two cells in each group of three cells fails then the array will continue to operate but at a reduced voltage. Thus, referring to Figure 2, if cell 21 fails, there is still a connection between cells 20 and 22 (i.e. lead 20c) to permit continuing operation of the array. Similarly, if both cells 21 and 22 fail, cells 20 and 23 are interconnected via lead 20d. This facility to continue operation even after failure of one or more cells is applicable to all arrays of photovoltaic cells. In the standard systems of a single series connection of cells, failure of one cell causes failure of the whole array.

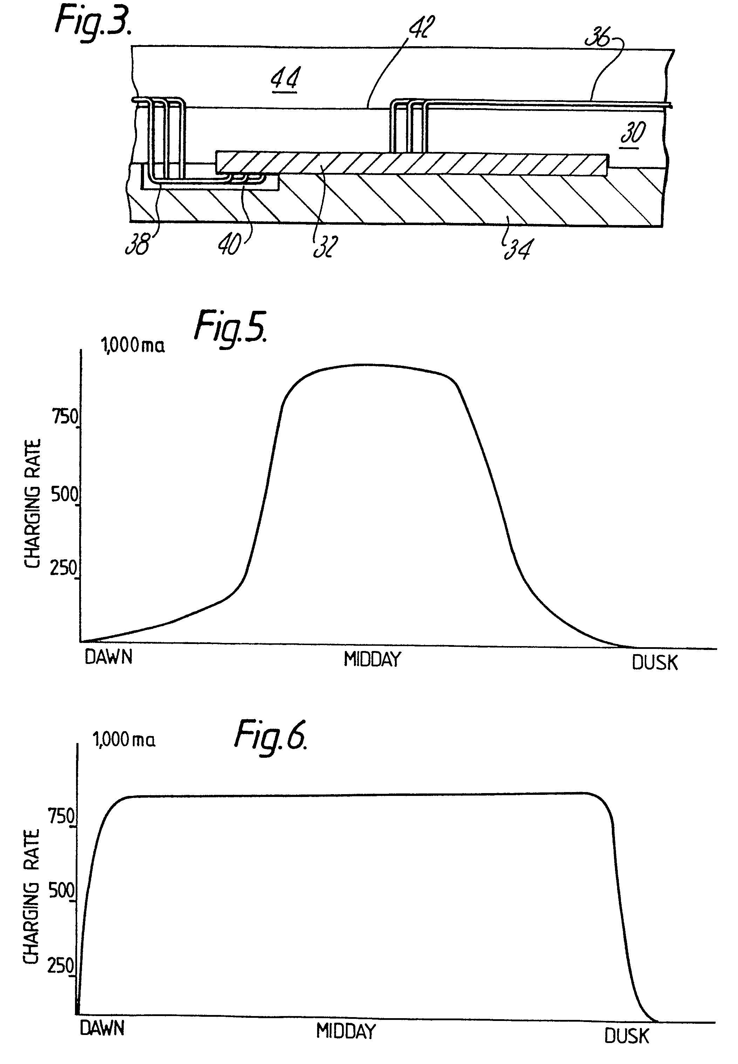

Next, as shown in Figure 3, a sub-layer 30 of clear silicon gel is formed over each cell 32 and the template 34, through which leads 36 from the central electrode of the cell 32 pass. The leads 38 from the doped surface of the cell 32, rest in a recess 40 in the template 34. The gel sub-layer 30 is allowed to harden and the leads 36 are pressed onto its exposed surface 42. Then a second sub-layer 44 of silicon gel is formed over the first layer 30 and allowed to harden. In this way the first layer 30 supports the leads 36 clear of the cell 32, to prevent damage to it, whilst the second sub-layer 44 holds the leads in place. It is preferable that at least some of the leads 36 are positioned so that they extend above the gaps between cells 32 in the array to prevent them blocking some of the light. It is desirable that the two gel layers 30,44 are stabilized against ultra-violet radiation.

When the second sub-layer 44 has hardened, the array is inverted into a flexible surface plate 46 (see Figure 4) with a surround 47, preferably integral with the plate, to form a recess into which the array fits exactly on the surface 48. The plate 46 is made of PLEXIGLASS G. To bond the second sub-layer 44 of silicon gel to the surface plate 46, a further thin sub-layer 50 of silicon gel may be used.

Then, finally, the template is removed and the exposed cells in the gel 30 are covered with a layer of surgical silicon gel 52. This is opaque and may be coloured to provide an overall colour to the panel, e.g. green or pink for camouflage.

In this way a flexible panel is produced. The crystals of the cells do not bend, which would crack them, but any movement is absorbed by the silicon gel layers 30 and 44. During any flexing of the panel,

and any panel will flex slightly under a very large stress, the leads expand and contract in length, as they are braided but do not contact the crystals except at the doped surface and the central electrode. Thus damage to the cells by the leads is prevented. If it is desired to make a rigid panel, the self-supporting 46 should be chosen from a material which imparts substantial rigidity to the panel. A substantially rigid backing plate 53 may be provided behind the sealant elastomer 52 to increase the rigidity of the panel. The backing plate 53 is secured to the surround 47 of the plate 46.

The plate 46 may have two parallel surfaces but, as shown in Figure 4, it is preferable that its light receiving surface 54 has a pyramidal configuration which in itself is new to photovoltaic panels. This configuration permits a greater amount of light to be transmitted through the plate than a flat light receiving surface because the latter reflects a greater proportion of light as the angle of incidence of the light on the surface increases. With a pyramid structure, the angle of incidence at the surface is lower for a greater range of angles of incidence to the panel as a whole. Figures 5 and 6 show this effect. In Figure 5 the charging rate produced by a panel with a plane glass surface is shown, (the perpendicular from the panel being directed towards the position of the sun at mid-day). It can be seen that the charging rate drops rapidly, except when the sun is almost perpendicular to the panel. With a pyramidal configuration however (Figure 6) the charging rate is approximately constant over a large part of the sun's arc.

The present invention is applicable to a large number of uses, where a robust, flexible photovoltaic panel is needed, e.g., in a rugged battery charger. It finds particular application in military uses where it is necessary that the panel should not be damaged by battlefield conditions. The fact that one or more cells can fail and the panel still be operational permits operation even after bullet damage. It has been found that the hole produced by a bullet passing through the panel is sealed by silicon gel, as the heat from the bullet melts the gel which then forms a coating along the inside of the hole. In this way, the hole has sealed itself against, e.g. damage by water.

A panel according to the present invention is light and does not shatter easily. It can be watertight, pressure resistant and vibration absorbent.

CLAIMS:

1.    A photovoltaic panel having a plurality of photovoltaic crystals (32) and a supporting structure (30,44,46,52);

characterised in that:

the supporting structure comprises two elastomeric layers, (30,44,52) one of which (44) is transparent, the crystals (32) being held between otherwise contiguous faces of the layers (30,44) and a self-supporting plate (46) of transparent plastics material on an outer surface of the transparent elastomeric layer (30,44).

2.    A photovoltaic panel according to Claim 1, wherein the transparent elastomeric layer (30,44) has two sub-layers (30,44) electrical elements (36,38) interconnecting the crystals (32) being supported between the two sub-layers (30,44).

3.    A panel according to Claim 1 or Claim 2, wherein the transparent elastomeric layer (30,44) is formed by clear silicon gel and the other elastomeric layer (52) is formed by surgical silicon gel.

4.    A photovoltaic panel comprising a plurality of photovoltaic crystals (32) and a supporting structure (30,44,46,52);

characterised in that:

the supporting structure (30,44,46,52) has a self-supporting plate (46) of transparent plastics material, the outer surface (54) of the plate (46) being pyramidally honeycombed, the peaks of the pyramids of which project inwardly and outwardly of a median plane of the honeycombed surface, the outer surface (34) of the plate (46) being the light-receiving surface of the panel.

5. A panel according to Claim 4, wherein the crystals (32) are held between contiguous faces of two elastomeric layers (30,44,52), one of the elastomeric layers (30,44) being transparent, the self-supporting plate (46) being fixed to an outer surface (50) of the transparent elastomeric layer (30,44).

6. A panel according to any one of Claims 1 to 3 or 5, wherein the self-supporting plate (46) and/or the transparent elastomeric layer (30,44) is stabilized against ultra-violet radiation.

7. A photovoltaic panel comprising a plurality of photovoltaic crystals (32) and a support structure (30,44,46,52);

characterised in that:

each crystal (32) is electrically connected directly to 2n other crystals (n being an integer not less than 2) to form groups of n crystals (32) with each crystal (32) belonging to n groups, whereby a series connection of crystals (32) is maintained even if (n-1) of the crystals (32) of any group is rendered inoperative.

8.    A panel according to Claim 7, wherein each direct connection (26,38) between the crystal (32) is conductive to electricity in one direction only.

9.    A panel according to any one of the preceding Claims, wherein each crystal (32) of the plurality of crystals has a doped face and an undoped face and the crystals are interconnected by electrical elements (36,38) each formed by a plurality of braided discrete flexible conductors electrically interconnecting a doped face of one crystal (32) of the plurality of crystals with another face of another crystal of the plurality of crystals.

10.    A method of manufacturing a photovoltaic panel having a plurality of photovoltaic crystals (32) and a supporting structure (30,44,46,52)

characterised in that the method comprises:

(a)  placing the plurality of crystals (32) in a template (34) with their light-receiving surface exposed:

(b) previous to or after (a) electrically interconnecting the crystals (32);

(c) pouring one or more layers (30,44) of transparent settable elastomer over the template (34) and the crystals (32);

(d) setting the transparent elastomer (30,44);

(e) inverting the assembly of crystals (32) and transparent elastomer (30,44) onto a self-supporting transparent plate (46) and securing a surface of the elastomer (30,44) to the plate (46); and

(f) sealing over the rear faces of the crystals (32) and transparent elastomer (30,44) with another elastomer layer (52).

Fig.1.

12

12

14

16

10

Fig.4.

47    52    32    53    38

30

36    44

54    46    48    50

Fig.2.

*Fig.3.*

*Fig.5.*

*Fig.6.*